# EUROPEAN PATENT SPECIFICATION

(11) **EP 1 272 016 B1**
(45) Date of publication and mention of the grant of the patent: **21.03.2007**
(21) Application number: 02013312.0
(22) Date of filing: 18.06.2002
(51) Int. Cl.: H05K 1/02, H05K 3/34

(54) **Resin-molded board**
Harzgegossene Platte
Carte moulée en résine

(30) Priority: 18.06.2001 JP 2001183306; 30.05.2002 JP 2002157324
(43) Date of publication of application: 02.01.2003
(73) Proprietor: CANON KABUSHIKI KAISHA, Ohta-ku, Tokyo (JP)
(72) Inventor: Yokoyama, Yukio, Ohta-ku, Tokyo (JP); Someya, Keisuke, Ohta-ku, Tokyo (JP)
(74) Representative: Weser, Wolfgang

(56) References cited:
- EP-A- 0 429 664
- US-A- 3 978 375
- PATENT ABSTRACTS OF JAPAN vol. 1998, no. 03, 27 February 1998 (1998-02-27) & JP 09 290434 A (HITACHI CABLE LTD), 11 November 1997 (1997-11-11)
- PATENT ABSTRACTS OF JAPAN vol. 1995, no. 06, 31 July 1995 (1995-07-31) & JP 07 058422 A (HITACHI LTD ET AL.), 3 March 1995 (1995-03-03)
- PATENT ABSTRACTS OF JAPAN vol. 015, no. 108 (E-1045), 14 March 1991 (1991-03-14) & JP 03 001598 A (KYUSHU HITACHI MAXELL LTD), 8 January 1991 (1991-01-08)
- PATENT ABSTRACTS OF JAPAN vol. 1999, no. 13, 30 November 1999 (1999-11-30) & JP 11 220231 A (MATSUSHITA ELECTRIC IND CO LTD), 10 August 1999 (1999-08-10)
- PATENT ABSTRACTS OF JAPAN vol. 014, no. 411 (E-0973), 5 September 1990 (1990-09-05) & JP 02 155288 A (NIPPON AVIONICS CO LTD), 14 June 1990 (1990-06-14)

## Description

### BACKGROUND OF THE INVENTION

### Field of the Invention

This invention relates to a resin-molded board, and in particular to a resin-molded board in which a metal frame that has been formed into a circuit pattern shape by pressing, etching or the like is sealed in a resin by resin molding.

### Description of the Related Art

In recent years, accompanying demands to make electronic apparatuses smaller in size and of higher capabilities, the mounting density of electronic components has been increased, and surface mounting with no lead wires has become more common, and along with technological advances in making printed boards multilayer and making electronic components smaller, there has been progress in the development of technology for increasing the mounting density of electronic components on printed boards.

However, in the field of electronic apparatuses that handle large currents, printed boards are comprised of a circuit pattern formed from extremely thin copper foil of thickness 0.18 to 0.7µm on glass epoxy resin or paper phenol resin. To increase the current-carrying capacity, it is thus necessary to make the circuit pattern cover a large area, and to secure sufficient electrical insulation, it is necessary to make the distance between electronic components and between circuit patterns at least a certain value. For such reasons, the development of technology for increasing mounting density has not been advancing, and in particular the miniaturization of board units with large current control parts is lagging behind, and as a result the miniaturization of electronic apparatuses is lagging behind.

Furthermore, regarding printed board units with large current control parts, the electronic components themselves are often large and heavy, and hence there has been a problem that the lands (electrode parts) on printed boards on which electronic components have been soldered may come off due to vibration or the like. Moreover, there has also been a problem that, to prevent electronic components from contacting one another, it is necessary to fix the electronic components with an adhesive, and hence the manufacturing cost increases. As one form of a circuit pattern board for overcoming such problems and achieving miniaturization, a resin-molded board has been contrived in which a metal frame on which a circuit pattern has been formed is covered with a resin. A resin-molded board is generally comprised of a metal frame sealed in a resin by resin molding, wherein the metal frame is made by forming a thin copper or brass plate of thickness about 0.5mm into a desired circuit pattern shape by pressing or etching. The thin copper or brass plate through which current flows is thick compared with a printed board, and hence a large current circuit pattern with a smaller pattern width can be formed. Moreover, because the metal frame is covered by a resin, electrical insulation is excellent. Such a resin-molded board is thus particularly effective as a primary side electronic circuit pattern board that handles a large AC current, such as an inverter circuit of a power source circuit pattern board or the like.

An injection molding machine, which gives good production efficiency, is used in the resin molding for covering the metal frame. PPS (polyphenylene sulfide) or PBT (polybutylene terephthalate) is generally used as the resin material. The metal frame has lands (electrode parts) for connecting and soldering on electronic components in predetermined positions, and hence circular openings for exposing the lands (hereinafter referred to as "openings for lands") are provided on a surface of the resin-molded board.

A flow soldering method using molten solder is used as the method of soldering the electronic components onto the resin-molded board. In the flow soldering method, soldering is carried out by squirting molten solder out from a solder tank, and making the molten solder come into contact with the surface to be soldered of the resin-molded board, which is conveyed in by a conveying unit. In this method, to carry out good soldering on the resin-molded board, flux is applied in advance onto the surface of the board to be soldered using a flux applying device called a fluxer. This flow soldering method is particularly effective in the case that the resin-molded board has flat surfaces.

In the case of a normal printed board, soldering can be carried out well if the molten solder is heated to about 250°C in advance and the land parts are heated to about 130°C in advance. However, in the case of a resin-molded board as described above, each of the frame parts of the metal frame has a large thickness and a large width, and hence the thermal capacity is extremely high. It is thus difficult to make the lands hot by heating, this resulting in that the heat travels through the metal frame away from the lands by thermal conduction. There has thus been a problem that the lands cannot be made to reach the temperature required in advance for soldering, and hence soldering defects are prone to occur. In particular, for a land on a frame part of the metal frame formed parallel to the direction of conveyance of the resin-molded board during soldering, when the land is heated during the soldering, the heat escapes from the land through thermal conduction, traveling to a portion of the metal frame that has not yet been heated and is thus at a lower temperature. It is thus even harder to make the land hot, and hence soldering of the land cannot be carried out at a suitable temperature. Moreover, in the case of a land provided in a frame part of the metal frame which has a large area, the influence of escape of heat through the metal frame becomes even greater.

When the flow soldering method is used with a printed board, in general preheating of the printed board is carried out. In the case of a resin-molded board, however, the board should be preheated to a temperature above 130°C, but because the thermal capacity is high, such preheating requires a long time, and hence it has been difficult to cope just by preheating since then the production cost is high.

JP 09 290434 proposes to reduce escaping heat during soldering by providing a recessed groove around the mounting hole part for soldering a connecting part of an electroconducting lead part.

### SUMMARY OF THE INVENTION

It is an object of the present invention to provide a resin-molded board that enables soldering of electronic components to the metal frame of the resin-molded board to be carried out well, with no increase in production cost.

To attain the above object, the present invention provides a resin-molded board comprising a metal frame having a plurality of frame parts that form an electric circuit pattern, and a resin layer molded onto the metal frame, wherein the resin layer has provided in a surface thereof first openings for soldering electronic components onto lands provided on said frame parts, each of the first openings having exposed therein a corresponding one of the lands, and second openings associated with the first openings, respectively, are provided in the surface of the resin layer on predetermined portion of the frame parts for maintaining, by soldering to the metal frame parts at the second openings the temperature of said lands in the associated first openings at not less than a predetermined temperature for a predetermined time when soldering the electronic components onto the lands in the first openings using a flow soldering method.

According to the present invention, the resin layer formed on the metal frame has a surface thereof formed therein with first openings (openings for lands) for exposing the metal frame and carrying out soldering of electronic components onto the metal frame, and second openings for maintaining the temperature at the first openings at not less than a predetermined temperature when soldering the electronic components onto the metal frame in the first openings using the flow soldering method. As a result, soldering of electronic components onto the metal frame via the first openings can be carried out well. Moreover, the shapes of the openings are determined through the shape of the molding die used when molding the resin, and hence even if there are several second openings, there is virtually no increase in production cost.

Preferably, each of the second openings has exposed therein one of the frame parts that is exposed in an associated one of the first openings.

As a result, soldering of electronic components onto the metal frame via the first openings can be carried out yet better.

More preferably, each of the second openings is provided in a vicinity of the associated one of the first openings.

As a result, soldering of electronic components onto the metal frame via the first openings can be carried out yet better.

Preferably, at least one of the frame parts extend in a direction approximately parallel to a direction of conveyance of the resin-molded board during soldering of electronic components onto the metal frame, and wherein the second openings are provided in at least one position out of in front of and behind the associated one of the first openings on a corresponding one of the frame parts that extend approximately parallel to the direction of conveyance of the resin-molded board.

As a result, soldering of electronic components onto the metal frame via the first openings can be carried out yet better.

The above and other objects, features and advantages of the invention will become more apparent from the following detailed description taken in conjunction with the accompanying drawings.

### BRIEF DESCRIPTION OF THE DRAWINGS

FIG. 1 is a perspective view showing the external appearance of a resin-molded board according to an embodiment of the present invention; and
FIG. 2 is a partial perspective view showing in detail the constitution of essential parts of the resin-molded board appearing in FIG. 1.

### DETAILED DESCRIPTION OF THE PREFERRED EMBODIMENTS

An embodiment of the present invention will now be described in detail with reference to the drawings.

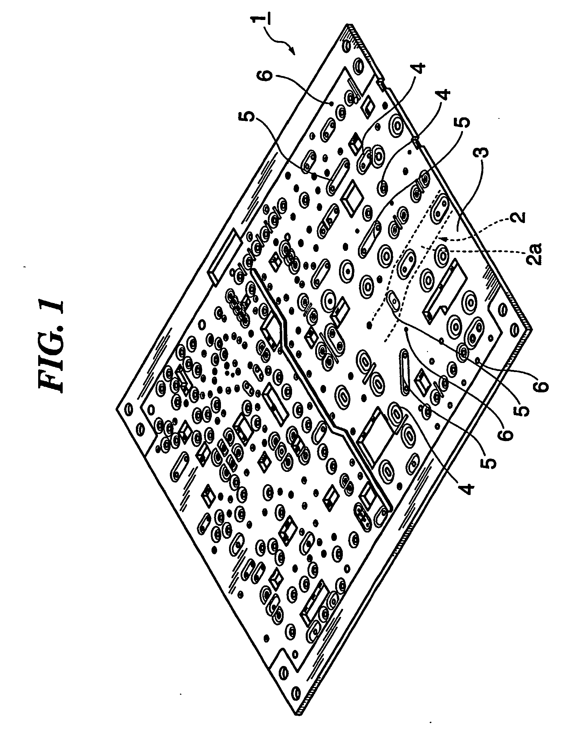

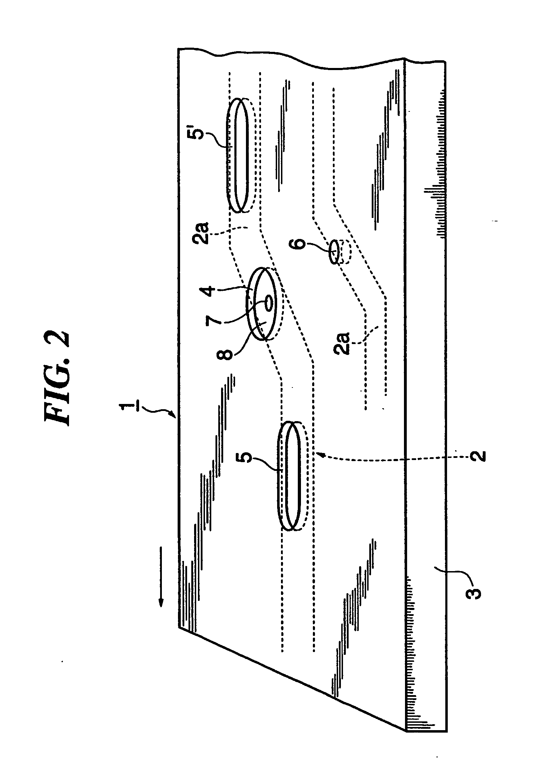

FIG. 1 is a perspective view showing the external appearance of a resin-molded board according to an embodiment of the present invention. FIG. 2 is a partial perspective view showing in detail the constitution of essential parts of the resin-molded board appearing in FIG. 1.

In FIGS. 1 and 2, the resin-molded board 1 is comprised of a metal frame 2 that forms an electric circuit pattern, and a resin layer 3 that covers both top and bottom surfaces of the metal frame 2. The metal frame 2 is comprised of a plurality of frame parts 2a that form various portions of the electric circuit pattern. A plurality of lands (electrode parts) 8 for connecting and soldering electronic components are provided in predetermined positions on the frame parts 2a. Formed in a surface of the resin-molded board 1 are circular or elliptical first openings (openings for lands) 4 that are for exposing the lands 8 and are provided in positions corresponding to the positions of the lands 8. Circular or elliptical second openings (openings for temperature maintenance) 5 and 5' are formed in the vicinity of the first openings 4, as well as third openings 6 for alignment that are used when molding the resin-molded board 1 for aligning the metal frame 2 with a molding die.

The metal frame 2 is made of a copper plate of thickness 0.5mm, and the metal frame 2 has been subjected to etching or pressing such that the frame parts 2a form a desired circuit pattern. The resin-molded board 1 is formed by placing the metal frame 2 in the molding die, and insert molding the resin layer 3 using an injection molding machine. A thermoplastic resin is preferable as the material used in the resin layer 3; PPS (polyphenylene sulfide) is particularly preferable. It is preferable to use PPS having a CTI (comparative tracking index) of 170.

As shown in FIG. 2, a component insertion hole 7 for inserting an electronic component is provided in a predetermined position (the center in FIG. 2) in the surface of each land 8, which is exposed in the corresponding first opening 4. The component insertion holes 7 are formed to a diameter in a range of 1 to 2.6mm. Each of the first openings 4 has a circular shape centered on the corresponding component insertion hole 7, and has a diameter in a range of 3 to 7mm. In the case that the first openings 4 are very close to one another in particular, to increase the apparent creepage distance of the mounted electronic components, projections (not shown) of height about 1mm may be formed on the surface of the resin-molded board 1 in positions between the first openings 4.

The second openings 5 and 5' are for maintaining the temperature of the lands 8 in the first openings 4 at a predetermined temperature or above when soldering electronic components to the lands 8 in the first openings 4 using the flow soldering method. The second openings 5 and 5' are provided in predetermined positions in front of and behind the first openings 4 in the direction of conveyance of the resin-molded board 1 during soldering (the direction of the arrow in FIG. 2) on frame parts 2a formed parallel to the direction of conveyance.

The third openings 6 are openings for alignment that are used when molding the resin-molded board 1 for aligning the metal frame 2 with the molding die; they are necessary for manufacturing the resin-molded board 1. The positions and size of the third openings 6 are set in accordance with the size and usage of the resin-molded board 1. Moreover, it is also possible to make the third openings 6 have the function of the second openings 5 and 5', and thus use the third openings 6 as the second openings 5 and 5' as well.

A description will now be given of the function of the second openings 5 and 5' when soldering electronic components onto the metal frame 2 of the resin-molded board 1. To carry out the soldering well, it is necessary to maintain the lands 8 to be soldered at a certain predetermined temperature or above for a certain predetermined time. In FIG. 2, the resin-molded board 1 is conveyed in the conveyance direction (the direction of the arrow in FIG. 2), whereupon soldering is carried out progressively from the left side to the right side of FIG. 2 using molten solder that is squirted out from a solder tank.

First, soldering to the metal frame 2 is carried out at the second opening 5. Due to molten soldering being deposited at the second opening 5, the corresponding frame part 2a of the metal frame 2 is heated. This heat travels by thermal conduction to a portion of the frame part 2a that has not yet been heated and is thus at a lower temperature, i.e. to the right in FIG. 2. The temperature of the land 8 on the frame part 2a thus rises. The land 8 has thus already been heated at some extent by the time soldering is carried out at the first opening 4.

Next, the resin-molded board 1 is conveyed further, and an electronic component is soldered on via the first opening 4. Due to soldering being carried out at the first opening 4, the land 8 is heated further. It is difficult to make the land 8 hot because the frame part 2a has a large thermal capacity, but because heating has already been carried out to some extent via the second opening 5, it is possible to heat the land 8 to a higher temperature in a shorter time. Since the land 8 can thus be more quickly heated to the predetermined temperature required for soldering to the land 8 or above, solder can be attached to the land 8 reliably.

Next, the resin-molded board 1 is conveyed yet further, and soldering is carried out at the second opening 5'. Due to molten soldering being provided at the second opening 5', the frame part 2a is heated further on. This heat travels by thermal conduction to a portion of the frame part 2a that has not yet been heated and is thus at a lower temperature, i.e. to the right in FIG. 2, but also travels by thermal conduction to the portion of the frame part 2a that has already been heated once, i.e. to the left in FIG. 2. The land 8 can thus be maintained at a higher temperature, and hence the solder can be attached to the land 8 even more reliably.

As described above, due to the presence of the second openings 5 and 5', the land 8 at the first opening 4 can be maintained at a certain predetermined temperature required for soldering or above for a longer predetermined time during soldering.

The spacing between the second openings 5 and 5' and the first opening 4 and the size of the second openings 5 and 5' are varied as necessary according to the size of the resin-molded board 1, the size of the frame part 2a of the metal frame 2, the temperature of the solder, the speed of conveyance of the resin-molded board 1, and so on. Nevertheless, the spacing between the second openings 5 and 5' and the first opening 4 is preferably in a range of 3 to 20mm. If the spacing between the second openings 5 and 5' and the first opening 4 is less than 3mm, then solder that should be used in the first opening 4 will be taken up by the second openings 5 and 5', and it will not be possible to secure a sufficient creepage distance for the mounted electronic components. On the other hand, if the spacing between the second openings 5 and 5' and the first opening 4 exceeds 20mm, then the amount of heat that travels along the frame part 2a will be too low.

Moreover, the width of the second openings 5 and 5' is approximately the same as the width of the frame part 2a, and preferably in a range of 3 to 7mm, and the length of the second openings 5 and 5' is preferably in a range of 5 to 20mm. If the length of the second openings 5 and 5' is less than 5mm, then the amount of heat that travels along the frame part 2a will be too low, whereas if this length exceeds 20mm, then the effects of covering the metal frame 2 with resin, which is a characteristic feature of the resin-molded board 1, will be lost.

In FIG. 2 the second openings 5 and 5' have an elliptical shape, but there is no such limitation. Moreover, in FIG. 2 the second openings 5 and 5' are provided in front of and behind the first opening 4 in the direction of conveyance of the resin-molded board 1 during soldering, but it is also possible to provide the second opening only in front of or only behind the first opening 4. Nevertheless, the effects of the present invention are greater if second openings are provided both in front of and behind the first opening 4.

In the embodiment described above, a description was given regarding second openings 5 and 5' positioned near to the first opening 4 on the frame part 2a that is formed parallel to the direction of conveyance of the resin-molded board 1 during soldering. However, the second openings 5 and 5' do not necessarily have to be provided on a frame part 2a that is parallel to the direction of conveyance. Nevertheless, the effects of the present invention are greater if the second openings 5 and 5' are provided on a frame part 2a that extends in a direction approximately parallel to the direction of conveyance.

## Claims

1. A resin-molded board (1), comprising:
a metal frame (2) having a plurality of frame parts (2a) that form an electric circuit pattern; and
a resin layer (3) molded onto said metal frame (2);
wherein said resin layer (3) has provided in a surface thereof first openings (4) for soldering electronic components onto lands (8) provided on said frame parts (2a), each of said first openings (4) having exposed therein a corresponding one of said lands (8),
**characterized in that** second openings(5, 5') associated with said first openings (4), respectively, are provided in said surface of said resin layer (3) on predetermined portions of said frame parts (2a), for maintaining, by soldering to the metal frame parts (2a) at the second openings (5, 5'), the temperature of said lands (8) in associated first openings (4) at not less than a predetermined temperature for a predetermined time when soldering the electronic components onto said lands (8) in said first openings (4) using a flow soldering method.

2. A resin-molded board as claimed in claim 1, wherein each of said second openings (5, 5') is provided in a vicinity of the associated one of said first openings (4).

3. A resin-molded board as claimed in claim 1, wherein at least one of said frame parts (2a) extends in a direction approximately parallel to a direction of conveyance of the resin-molded board (1) during soldering of electronic components onto said lands (8), and wherein said second openings (5, 5') are provided in at least one position out of in front of and behind the associated one of said first openings (4) on a corresponding one of said frame parts (2a) that extend approximately parallel to the direction of conveyance of the resin-molded board (1).

## Patentansprüche

1. Kunststoff-geformte Platine, umfassend
einen Metallrahmen (2) mit einer Mehrzahl Rahmenteile (2a), die ein elektrisches Schaltungsmuster bilden, und
eine auf dem Metallrahmen (2) geformte Kunststoffschicht (3), die in einer Oberfläche versehen ist mit ersten Öffnungen (4) zum Löten elektronischer Komponenten auf Anschlussflächen (8), die auf den Rahmenteilen (2a) vorgesehen sind, wobei jede der ersten Öffnungen (4) eine darin frei gelegte Anschlussfläche (8) aufweist,
**dadurch gekennzeichnet, dass**
den ersten Öffnungen (4) zugeordnete zweite Öffnungen (5, 5') in der Oberfläche der Kunststoffschicht (3) auf vorbestimmten Abschnitten der Rahmenteile (2a) vorgesehen sind, um beim Löten an die Metallrahmenteile (2a) in den zweiten Öffnungen (5, 5') die Temperatur der Anschlussflächen (8) in zugeordneten ersten Öffnungen (4) eine vorbestimmte Zeit lang auf nicht weniger als eine vorbestimmte Temperatur zu halten, wenn die elektronischen Komponenten auf die Anschlussfläche (8) in den ersten Öffnungen (4) unter Nutzung eines Schwall-Lötverfahrens gelötet werden.

2. Platine nach Anspruch 1, bei der
jede der zweiten Öffnungen (5, 5') benachbart zu einer zugeordneten der ersten Öffnungen (4) vorgesehen ist.

3. Platine nach Anspruch 1, bei der
mindestens eines der Rahmenteile (2a) in annähernd paralleler Richtung zur Vorschubrichtung der Platine (1) während des Lötens der elektronischen Komponenten auf die Anschlussflächen (8) verläuft, und wobei die zweiten Öffnungen (5, 5') vorgesehen sind in mindestens einer Position außerhalb der Vorderseite und hinter der zugeordneten der ersten Öffnungen (4) auf einem entsprechenden der Rahmenteile (2a), die sich annähernd parallel zur Vorschubrichtung der Platine (1) erstrecken.

## Revendications

1. Carte moulée en résine (1), comprenant :
une structure métallique (2) comportant une pluralité de parties de structure (2a) qui forment un motif de circuit électrique, et
une couche de résine (3) moulée sur ladite structure métallique (2),
dans laquelle ladite couche de résine (3) comporte prévues dans une surface de celle-ci des premières ouvertures (4) pour souder des composants électroniques sur des plages (8) prévues sur lesdites parties de structure (2a), chacune desdites premières ouvertures (4) comportant exposée dans celle-ci une plage correspondante parmi lesdites plages (8),
**caractérisée en ce que** des secondes ouvertures (5, 5') associées auxdites premières ouvertures (4), respectivement, sont prévues dans ladite surface de ladite couche de résine (3) sur des parties prédéterminées desdites parties de structure (2a) pour maintenir, en soudant les parties de structure métallique (2a) au niveau des secondes ouvertures (5, 5'), la température desdites plages (8) dans les premières ouvertures (4) associées à une température qui n'est pas inférieure à une température prédéterminée pendant un temps prédéterminé lors de la soudure des composants électroniques sur lesdites plages (8) dans lesdites premières ouvertures (4) en utilisant un procédé de soudure à la vague.

2. Carte moulée en résine selon la revendication 1, dans laquelle chacune desdites secondes ouvertures (5, 5') est prévue dans un voisinage de l'ouverture associée parmi lesdites premières ouvertures (4).

3. Carte moulée en résine selon la revendication 1, dans laquelle au moins l'une desdites parties de structure (2a) s'étend dans une direction approximativement parallèle à une direction de transport de la carte moulée en résine (1) au cours de la soudure de composants électroniques sur lesdites plages (8), et dans laquelle lesdites secondes ouvertures (5, 5') sont prévues dans au moins une position soit devant, soit derrière l'ouverture associée parmi lesdites premières ouvertures (4) sur une partie correspondante desdites parties de structure (2a) qui s'étendent de manière approximativement parallèle à la direction de transport de ladite carte de résine moulée (1).
